# FASCICULE DE BREVET EUROPEEN

(11) **EP 0 614 126 B1**
(45) Date de publication et mention de la délivrance du brevet: **06.02.2002**
(21) Numéro de dépôt: 94400427.4
(22) Date de dépôt: 01.03.1994
(51) Int. Cl.: G03F 7/40, G03F 7/022

(54) **Procédé de formation d'un motif de photorésist sur la surface d'un substrat et solution de photorésist comprenant un composé oxydant**
Verfahren zur Herstellung eines Resistmusters sowie ein Oxidationsmittel enthaltender Photoresist
Process for making a photoresist pattern and photoresist composition containing an oxidising compound

(30) Priorité: 02.03.1993 FR 9302384
(43) Date de publication de la demande: 07.09.1994
(73) Titulaire: FRANCE TELECOM, 75015 Paris (FR)
(72) Inventeur: Weill, André, F-38240 Meylan (FR); Romand, Philippe, F-38700 La Tronche (FR)
(74) Mandataire: Casalonga, Axel

(56) Documents cités:
- DE-A- 3 305 934
- GB-A- 2 169 608
- US-A- 4 521 450
- DATABASE WPI Week 8444, Derwent Publications Ltd., London, GB; AN 84-274143 & SU-A-772 396 (MOLODNYAKOV)

## Description

La présente invention concerne de manière générale un procédé de formation d'un motif de photoréserve sur la surface d'un substrat, et plus particulièrement un procédé de formation d'un motif de photoréserve copolymérisé conducteur sur un substrat semi-conducteur, par exemple du silicium. L'invention concerne également une solution de photoréserve comportant un composé oxydant convenant particulièrement pour la mise en oeuvre dudit procédé.

Dans le domaine de la micro-électronique, et plus particulièrement dans le domaine de fabrication des circuits intégrés, il est classique pour la fabrication de tels circuits de recouvrir la surface d'un substrat, tel qu'un substrat semi-conducteur, par exemple du silicium, avec un mince film de matériau photosensible (généralement désigné dans la technique par le terme de photoréserve), de former dans ce film de photoréserve par photolithographie travers un masque, une image de motifs voulus, et de développer l'image ainsi formée dans le mince film de photoréserve au moyen d'un agent de développement approprié. Les motifs de photoréserve sont généralement ensuite transférés dans le substrat sous-jacent, par exemple, par la technique de gravure en plasma réactif. Enfin, la photoréserve est enlevée par des procédés bien connus dans la technique.

Les photoréserves comprennent de manière générale une matrice d'un matériau polymère et un composé photosensible. Le composé photosensible ou photoinitiateur devient actif par absorption d'énergie entre 190 - 450 nm et induit la réticulation de la zone insolée (cas des pholoréserves dites négatifs). Ces polymères sont solubles, s'ils n'ont pas été exposés et pendant le développement, seule la partie insolée reste sur le substrat et servira comme masque de gravure.

Les photoréserves dites positives agissent à l'inverse, c'esi-à-dire qu'elles deviennent solubles par l'action de la lumière.

Les polymères mis en jeu sont généralement des novolaques, des polyimides ou des polyvinylphénols (ou polyhydroxystyrènes) rendus solubles ou insolubles par la lumière sous l'effet du photo-initiateur.

Au cours de leurs utilisations et de leurs traitements ultérieurs, les motifs de photoréserve sont souvent soumis à un bombardement de particules chargées. Ce bombardement, se traduit généralement par un phénomène d'accumulation de charges électriques (ou effet de charge) dans les films minces de photoréserve. Dans le cadre de la microélectronique par exemple, ce phénomène apparaît, notamment, lors de la mise en oeuvre des trois techniques suivantes :
l'observation et la métrologie des motifs de photoréserve selon la technique de microscopie électronique par balayage (MEB); la gravure en plasma réactif pour le transfert des motifs de photoréserve dans le substrat sous-jacent; et l'utilisation de la lithographie par faisceaux d'électrons pour l'écriture de l'image latente dans le film de photoréserve.

Lors de la mise en oeuvre de ces trois techniques par exemple, les motifs de photoréserve sont soumis à un bombardement ionique ou électronique qui induit un processus d'accumulation de charges électriques. Il en résulte une dégradation très sensible des performances obtenues. On peut, par exemple, indiquer pour chacune de ces trois techniques, la distorsion et le manque de netteté de l'image observée au MEB et donc l'erreur de mesure induite en métrologie MEB, la variation de la vitesse de gravure en fonction du facteur d'aspect des motifs, c'est à dire en fonction du rapport profondeur/ largeur, et l'erreur de positionnement du faisceau électronique sous l'effet du champ électrique local.

On sait d'autre part que le temps caractéristique de dispersion d'une charge électrique dans un matériau, τ, varie selon l'équation τ = ρ ε où ρ et ε sont, respectivement, la résistivité électrique et la constante diélectrique du matériau. Par conséquent, une forte résistivité électrique (ρ égal à environ 10¹⁴ Ω.cm) des matériaux polymères, et donc des photoréserves conventionnelles, qui généralement comprennent une matrice novolaque, augmente considérablement le temps d'évacuation des charges accumulées dans le matériau.

Afin d'éviter ce phénomène d'accumulation de charge plusieurs techniques ont été proposées, mais elles présentent toutes de sérieux inconvénients.

Dans le cadre de l'observation des motifs de photoréserve par microscopie électronique par balayage, la solution la plus classique utilisée pour éliminer les charges consiste à pulvériser une fine couche métallique (typiquement 20 nanomètres d'or). Malheureusement cette technique s'avère destructrice car le métal déposé ne peut plus être enlevé.

Une autre solution pour diminuer l'effet de charge consiste à utiliser un faisceau électronique à basse énergie (1 keV par exemple), mais la grande majorité des équipements existants fonctionnent à haute énergie (20 keV). Non seulement cette technique à basse énergie requiert un équipement spécifique coûteux, mais la résolution ultime obtenue décroît considérablement avec la diminution d'énergie du faisceau utilisé.

Dans le cadre de la gravure en plasma réactif, il n'existe pas de solution technique bien établie pour supprimer les variations de vitesse de gravure en fonction de la géométrie des motifs à transférer, ce qui conduit à accepter une surgravure excessive des motifs les plus gros. Seule une modification des conditions du plasma peut réduire ce phénomène, mais une fois encore, au détriment du rendement du procédé.

Dans le cadre de la lithographie par faisceau électronique, on réalise la suppression des effets de charge, pour un système tri couches, par implantation d'ions (hydrogène 100 keV ou argon 40 keV) dans la couche inférieure. La graphitisation de la photoréserve qui en résulte, donne naissance à une certaine conductivité électrique, permettant d'homogénéiser la charge électrique. Toutefois, cette technique s'avère très pénalisante du point de vue du débit de plaque, car les doses d'implantation requises sont importantes, de l'ordre de 10¹⁶ atomes par cm². De plus cette technique nécessite un équipement extrêmement coûteux. Dans le cas d'un système monocouche, il n'existe à l'heure actuelle pas d'autre solution que de diminuer fortement l'intensité du courant électronique, ce qui à nouveau est très pénalisant en terme de débit de plaque.

Par ailleurs, le document GB-2,169,608 décrit un procédé de formation d'une couche conductrice par polymérisation d'un monomère, par exemple le pyrrole, en mettant en contact ledit monomère avec un composé polymérique contenant un catalyseur de polymérisation.

L'invention a donc pour but un procédé de formation d'un motif de photoréserve sur un substrat qui ne présente pas le phénomène d'accumulation de charges lorsque ce motif est soumis à un bombardement par des particules chargées.

L'invention a également pour but de fournir une solution de photoréserve contenant un composé oxydant.

Ces solutions de photoréserve modifiées, lorsqu'elles sont utilisées dans le procédé de la présente invention, permettent la formation d'un motif de photoréserve copolymérisé conducteur sur la surface du substrat. On obtient ainsi un motif ayant une faible résistivité électique et par conséquent un temps de dissipation des charges négligeable qui évite le phénomène d'accumulation de charges décrit ci-dessus.

Selon l'invention, le procédé de formation d'un motif de photoréserve sur un substrat comprend :
le dépôt sur une surface du substrat sous forme d'un film mince, uniforme et homogène d'une solution de photoréserve contenant un composé oxydant, le composé oxydant étant capable d'oxyder un monomère réducteur, soluble dans la solution de photoréserve, capable de former une solution solide homogène dans le film mince de photoréserve, chimiquement inerte, thermiquement stable et présentant une absorbance limitée dans la gamme de longueurs d'onde comprise entre 190 et 450 nm.
le chauffage du substrat et du film mince de photoréserve pour densifier le film de photoréserve;
le placement d'un masque pourvu d'un motif au-dessus du film de photoréserve;
la formation, par insolation du film de photoréserve à travers le masque, d'une image latente du motif;
le développement dans le film de photoréserve de l'image du motif; et
la diffusion dans le motif de photoréserve d'une vapeur d'un monomère réducteur pour former un motif de photoréserve copolymérisé conducteur sur le substrat.

Parmi les monomères réducteurs convenant pour la présente invention, on peut citer le pyrrole, et ses dérivés, le thiophène et ses dérivés.

Le procédé de l'invention peut comporter en outre une étape de séchage du film après le développement de l'image du motif et avant la diffusion de la vapeur de monomère.

Le procédé peut comporter en outre une étape de recuit classique, après l'étape de développement de l'image du motif dans le film de photoréserve et avant l'étape de diffusion de la vapeur de monomère. Il peut de plus comporter une étape de recuit avant développement.

De préférence, le dépôt de la solution de photoréserve sur la surface du substrat se fait, de façon classique, par centrifugation de manière à obtenir un film mince, uniforme et homogène ayant une épaisseur généralement comprise entre 0,1 et 2 µm. Egalement, l'étape d'insolation du film de photoréserve à travers le masque, s'effectue de façon classique, généralement par insolation par une lumière ultraviolette ayant une longueur d'onde comprise entre 190 et 450 nm. Le masque utilisé est également classique, par exemple, un masque de verre portant un motif de chrome.

La durée de l'étape de diffusion de la vapeur dépend de la teneur en composé oxydant de la solution de photoréserve et de la résistivité électrique voulue pour le motif copolymérisé conducteur de photoréserve. Généralement, la durée de l'étape de diffusion est comprise entre 2 et 10 heures. Si la durée de la diffusion de la vapeur de monomère réducteur est inférieure à 2 heures le motif de photoréserve ne présente pas la conductivité voulue et si la durée est supérieure à 10 heures il y a une dégradation des motifs.

On peut ainsi, en utilisant le procédé selon l'invention obtenir des motifs de photoréserve copolymérisés conducteurs dont la résistivité peut diminuer jusqu'à atteindre 1 Ω.cm en fonction de la concentration initiale en composé oxydant dans la solution et la durée du traitement de diffusion de la vapeur de monomère réducteur. Les motifs de photoréserve copolymérisés ainsi obtenus ne donnent plus lieu à des phénomènes d'accumulation de charges lorsqu'ils sont soumis à un bombardement électronique de type MEB 20 keV, et les effets de variation de vitesse de gravure par plasma sont fortement diminués.

On peut utiliser comme solution de photoréserve, toute solution classique du commerce à laquelle on a ajouté un composé oxydant. Ces solutions de photoréserve classiques comprennent généralement une matrice d'un matériau polymère filmogène, telle qu'une matrice novolaque, polyimide ou polyvinylphénol et un composé photosensible, par exemple une molécule du type diazonaphtoquinone. A cette solution de photoréserve classique on ajoute un composé oxydant. Le composé oxydant, bien évidemment ne doit pas perturber le caractère photosensible de la solution de photoréserve.

Les composés oxydants utilisables dans les solutions de photoréserve de la présente invention doivent :
- oxyder le monomère
- être solubles dans la solution de photoréserve;
- former une solution solide homogène (sans démixion) avec les autres composants chimiques dans le film mince de photoréserve;
- être chimiquement inertes vis-à-vis des réactifs photosensibles contenus dans la solution de photoréserve;
- être thermiquement stables au cours des différents traitements thermiques que subit la photoréserve (cuisson douce, cuisson post exposition), et notamment ne pas s'évaporer; et
- présenter une absorbance limitée (par exemple 0,3 µm⁻¹) à la longueur d'onde de la lumière d'insolation, comprise généralement entre 190 et 450 nm.

Parmi les composés oxydants ayant les propriétés ci-dessus on peut citer FeCl₃, le p-fluoranil, le p-chloranil, l'o-bromanil, la dichloro-2,3 dicyano-5,6 p-benzoquinone, Br₂, I₂, et CuCl₂. On recommande tout particulièrement d'utiliser le chlorure ferrique.

La quantité de composés oxydants introduite dans la solution de photoréserve est fonction du composé oxydant utilisé et peut être déterminée par des expérimentations de routine. Par exemple, dans le cas de FeCl₃, on obtient une solution de photoréserve convenant pour la présente invention en saturant une solution de photoréserve classique du commerce avec FeCl₃ puis en mélangeant, en volume, 1 partie de solution de photoréserve classique du commerce avec 0,2 à 1,5 parties de la solution saturée en chlorure ferrique.

Les monomères réducteurs utilisables dans la présente invention choisis parmi le pyrrole et ses dérivés, le thiophène et ses dérivés, doivent être aisément vaporisables et fournir des vapeurs qui soient :
- solubles dans le film solide de photoréserve;
- capables de diffuser rapidement dans ce film, et en particulier dans la matrice, par exemple une novolaque, du film de photoréserve;
- capables de réduire chimiquement le composé oxydant pour polymériser in-situ dans le film de photoréserve, en particulier dans la matrice, afin de lui conférer la propriété conductrice voulue;
- sans effet néfaste pour la suite du procédé, notamment l'étape d'enlèvement de la photoréserve après l'étape de gravure du substrat.

Parmi les dérivés du pyrrole on peut citer les alkyl-3-pyrroles, les akylsulfonate-3 pyrroles et les alkoxy-3 pyrroles. Parmi les alkyl -3 pyrroles on recommande le méthyl-3 pyrrole, l'éthyl-3 pyrrole, l'octyl-3 pyrrole et l'hendécanoyl-3 pyrrole.

Parmi les alkylsulfonate-3 pyrroles, on recommande l'éthylsulfonate-3 pyrrole et le butylsulfonate-3 pyrrole. Parmi les alkoxy-3 pyrroles, on recommande le méthoxy-3 pyrrole et l'éthoxy-3 pyrrole.

Parmi les dérivés du thiophène on peut citer les alkyl-3 thiophènes, les alkylsulfonate-3 thiophènes et les alkoxy-3 thiophènes. Parmi les alkyl-3 thiophènes, on recommande le méthyl-3 thiophène, l'éthyl-3 thiophène, le butyl-3 thiophène, l'octyl-3 thiophène et l'octadécyl-3 thiophène. Parmi les alkylsulfonate-3 thiophènes, on recommande l'éthylsulfonate-3 thiophène et le butylsulfonate-3 thiophène. Parmi les alkoxy-3 thiophènes, on recommande le méthoxy-3 thiophène et l'éthoxy-3 thiophène.

On recommande tout particulièrement le pyrrole et le thiophène.

### Exemple de préparation d'une solution de photoréserve contenant un composé oxydant.

A une solution de photoréserve du commerce référencée IX 500 (solution dans le solvant TRP 500 de polymère novolaque et de diazonaphtoquinone) distribuée par la société JSR/UCB (Japan Synthetic Rubber/ Union Chimique Belge), on ajoute jusqu'à saturation du chlorure ferrique anhydre vendu par la société MERCK. On active la dissolution du chlorure ferrique par une agitation douce pendant 100 minutes, puis on laisse décanter.

On mélange une partie en volume de la solution de photoréserve initiale du commerce avec une partie en volume de la solution saturée en chlorure ferrique obtenue ci-dessus et 0,4 partie en volume du solvant TRP 500 (mélange de méthyléthylcétone et de monoéthyléther d'acétate de propylène glycol) provenant de la société JSR/UCB. On active le mélangeage par agitation douce pendant 100 minutes, puis on filtre avec une ouverture de maille de 0,2 µm. On obtient ainsi une solution de photoréserve contenant un composé oxydant selon l'invention.

### Exemple de formation d'un motif de photoréserve copolymérisé conducteur sur un substrat.

On dépose par centrifugation la solution obtenue ci-dessus sur un substrat de silicium de manière à obtenir un film de 1 µm d'épaisseur. (La vitesse de rotation pour la centrifugation est de 4000 tours par minutes).

On compacte le film mince obtenu par une cuisson sur une plaque chauffante à 90°C pendant 1 minute.

On forme alors une image latente d'un motif, par photolithographie à travers un masque de verre supportant un motif de chrome à imprimer, en utilisant de la lumière ultraviolette de longueur d'onde 365 nanomètres avec une dose d'exposition de 200 mJ/ cm².

On effectue un recuit de post-exposition à 120°C pendant 1 minute.

On développe l'image latente formée à l'aide d'une dilution du développeur du commerce TMA 238 WA fourni par JSR. Ce développeur du commerce est une solution aqueuse basique (normalité 0,28N) contenant classiquement de l'hydroxyde de tétraméthylammonium, KOH et NaOH. Il a été préalablement dilué en utilisant 4 volumes d'agent de développement pour un volume d'eau distillée.

On sèche ensuite la plaquette au cours d'un recuit sur une plaque chauffante. Puis, dans un cristallisoir, on soumet le motif de photoréserve à l'action de la vapeur de pyrrole pendant 5 heures. On obtient ainsi un motif de photoréserve copolymérisé conducteur ayant une résistivité électrique de 1Ω.cm (conductivité de 1 Siemens /cm).

On a vérifié que ce motif copolymérisé conducteur ne donne plus lieu à des phénomènes d'accumulation de charge lorsqu'il est soumis à un bombardement électronique du type tel que la microscopie électronique par balayage à 20 keV, et que les effets de variation de vitesse de gravure par plasma sont fortement diminués.

## Revendications

1. Procédé de formation d'un motif de photoréserve sur une surface d'un substrat, par exemple en matériau semi-conducteur tel que du silicium, **caractérisé en ce qu'**il comprend :
- le dépôt sur la surface du substrat sous la forme d'un film mince uniforme et homogène d'une solution de photoréserve contenant un composé oxydant, le composé oxydant étant capable d'oxyder un monomère réducteur, soluble dans la solution de photoréserve, capable de former une solution solide homogène dans le film mince de photoréserve, chimiquement inerte, thermiquement stable et présentant une absorbance limitée dans la gamme de longueurs d'onde comprise entre 190 et 450 nm ;
- le chauffage du substrat et du film mince pour densifier le film de photorésist ;
- le placement d'un masque pourvu d'un motif au-dessus du film de photoréserve ;
- la formation, par insolation du film de photoréserve à travers le masque, d'une image latente du motif ;
- le développement dans le film de photoréserve de l'image du motif ; et
- la diffusion dans le motif de photoréserve d'une vapeur d'un monomère réducteur pour former un motif de photoréserve copolymérisé conducteur sur le substrat, le monomère réducteur étant choisi parmi le pyrrole et ses dérivés, et le thiophène et ses dérivés.

2. Procédé selon la revendication 1, comprenant en outre une étape de séchage du film après le développement de l'image du motif et avant la diffusion de la vapeur de monomère.

3. Procédé selon la revendication 1 ou 2, comprenant en outre une étape de recuit après l'insolation et avant l'étape développement;

4. Procédé selon l'une quelconque des revendications précédentes 1 ou 2, **caractérisé en ce que** le dépôt du film mince de solution de photoréserve s'effectue par centrifugation.

5. Procédé selon l'une quelconque des revendications précédentes, **caractérisé en ce que** le film mince de solution de photoréserve a une épaisseur de 0,1 à 2µm.

6. Procédé selon l'une quelconque des revendications précédentes, **caractérisé en ce que** la diffusion de la vapeur du monomère s'effectue pendant une période de 2 à 10 heures.

7. Procédé selon l'une quelconque des revendications précédentes, **caractérisé en ce que** le composé oxydant est choisi parmi le FeCl₃, Fe(CF₃SO₃)₃, le p-fluoranil, le p-chloranil, l'o-bromanil, la dichloro-2,3 dicyano-5,6 p-benzoquinone, Br₂, I₂ et CuCl₂.

8. Procédé de formation d'un motif de photoréserve sur une surface d'un substrat de silicium **caractérisé en ce qu'**il comprend :
le dépôt par centrifugation sur la surface du substrat de silicium d'une solution de photoréserve contenant une matrice novolaque, une molécule du type diazonaphtoquinone et du chlorure ferrique, sous la forme d'un film mince, uniforme et homogène ayant une épaisseur comprise entre 0,1 et 2µm. ;
le chauffage du substrat et du film mince pour obtenir un film densité de photoréserve ;
le placement au-dessus du film de photoréserve d'un masque de verre pourvu d'un motif ;
la formation dans le film de photorésist, par insolation à travers le masque par une lumière ultraviolette, d'une image latente du motif du masque ;
le recuit du film de photoréserve insolé ;
le développement dans le film de photoréserve de l'image du motif ;
le séchage du substrat et du film ; et
la diffusion dans le motif de photoréserve d'une vapeur de pyrrole pendant 2 à 10 heures pour former un motif de photoréserve copolymérisé conducteur sur le substrat.

9. Procédé selon la revendication 8, **caractérisé en ce que** l'étape de chauffage consiste à chauffer le substrat et le film mince à 90°C pendant 1 minute.

10. Procédé selon la revendication 8 ou 9, **caractérisé en ce que** le recuit s'effectue à 120°C pendant 1 minute.

11. Procédé selon l'une quelconque des revendications 8 ou 10, **caractérisé en ce que** l'étape de diffusion de la vapeur de pyrrole s'effectue pendant 5 heures.

12. Utilisation pour former sur une surface d'un substrat selon le procédé de la revendication 1 ou 8 un motif de photoréserve copolymérisé d'une solution de photoréserve comprenant une matrice de matériau polymère, un composé photosensible et un composé oxydant capable de provoquer la polymérisation d'un monomère réducteur choisi parmi le pyrrole, le thiophène et leurs dérivés, ledit composé oxydant étant soluble dans la solution de photoréserve capable de former une solution solide homogène dans le film mince de photoréserve, chimiquement inerte, thermiquement stable et présentant une absorbance limitée dans la gamme de longueurs d'onde comprise entre 190 et 450 nm

13. Utilisation selon la revendication 12, dans laquelle le composé oxydant est choisi parmi le FeCl₃, Fe(CF₃SO₃)₃, le p-fluoranil, le p-chloranil, l'o-bromanil, la dichloro-2,3 dicyano-5,6 p-benzoquinone, Br₂, I₂ et CuCl₂.

14. Utilisation selon la revendication 12 ou 13, dans laquelle la matrice de matériau polymère est une novolaque, un polyimide ou un polyvinylphenol.

15. Utilisation selon la revendication 14, dans laquelle la matrice est une novolaque, le composé photosensible est une diazonaphtoquinone et le composé oxydant le chlorure ferrique.

16. Utilisation selon la revendication 15, dans laquelle la solution de photoréserve comprend, en volume, 1 partie de solution de photorésist ne contenant pas de chlorure ferrique et 0,2 à 1,5 parties de cette même solution saturée en chlorure ferrique.

17. Solution de photoréserve utilisée dans le procédé selon la revendication 1 ou 8 comprenant une matrice de matériau polymère et un composé photosensible, **caractérisé en ce qu'**elle comprend en outre un composé oxydant choisi parmi FeCl₃, Fe(CF₃SO₃)₃, la dichloro-2,3 dicyano-5,6 p-benzoquinone et CuCl₂.

18. Solution de photoréserve selon la revendication 17, **caractérisée en ce que** la matrice de matériau est une novolaque, un polyimide ou un polyvinylphénol.

19. Solution de photoréserve selon la revendication 18, **caractérisée en ce que** la matrice est une novolaque, le composé photosensible une diazonaphtoquinone et le composé oxydant le chlorure ferrique.

20. Solution de photoréserve selon la revendication 19, **caractérisée en ce qu'**elle comprend, en volume,une partie de solution de photoréserve ne contenant pas de chlorure ferrique et 0,2 à 1,5 parties de cette même solution saturée en chlorure ferrique.

## Patentansprüche

1. Verfahren zur Bildung eines Photoresistmotivs auf einer Oberfläche eines Substrats, beispielsweise aus einem Halbleitermaterial, wie beispielsweise Silizium, **dadurch gekennzeichnet, daß** es umfaßt:
- das Aufbringen einer Photoresistlösung, die eine oxidierende Verbindung enthält, auf der Oberfläche des Substrats in Form einer dünnen, einheitlichen und homogenen Schicht, wobei die oxidierende Verbindung in der Lage ist, ein Reduktionsmonomer zu oxidieren, das in der Photoresistlösung löslich und in der Lage ist, eine feste homogene Lösung in der dünnen Photoresistschicht zu bilden, die chemisch inert, thermisch stabil ist und eine begrenzte Absorbierfähigkeit in dem Wellenlängenbereich zwischen 190 und 450 nm aufweist;
- das Erhitzen des Substrats und der dünnen Photoresistschicht, um die Photoresistschicht zu verdichten;
- das Anbringen einer Maske, die mit einem Motiv versehen ist, über der Photoresistschicht;
- das Bilden eines latenten Bildes des Motivs durch Sonnenbestrahlung der Photoresistschicht durch die Maske;
- das Entwickeln des Bildes und des Motivs in der Photoresistschicht; und
- die Diffusion eines Dampfes eines Reduktionsmonomers in dem Photoresistmotiv, um ein leitendes copolymerisiertes Photoresistmotiv auf dem Substrat zu bilden, wobei das Reduktionsmonomer unter dem Pyrrol und seinen Derivaten und dem Thiophen und seinen Derivaten ausgewählt wird.

2. Verfahren nach Anspruch 1, ferner umfassend einen Schritt des Trocknens der Schicht nach der Entwicklung des Bildes des Motivs und vor der Diffusion des Monomerdampfes.

3. Verfahren nach Anspruch 1 oder 2, ferner umfassend einen Ausglühschritt nach der Sonnenbestrahlung und vor dem Schritt der Entwicklung.

4. Verfahren nach einem der vorhergehenden Ansprüche 1 oder 2, **dadurch gekennzeichnet, daß** die Aufbringung der dünnen Schicht der Photoresistlösung durch Zentrifugieren erfolgt.

5. Verfahren nach einem der vorhergehenden Ansprüche, **dadurch gekennzeichnet, daß** die dünne Schicht der Photoresistlösung eine Dicke aufweist, die zwischen 0,1 und 2 µm liegt.

6. Verfahren nach einem der vorhergehenden Ansprüche, **dadurch gekennzeichnet, daß** die Diffusion des Monomerdampfes während einer Zeitdauer von 2 bis 10 Stunden erfolgt.

7. Verfahren nach einem der vorhergehenden Ansprüche, **dadurch gekennzeichnet, daß** die oxidierende Verbindung unter FeCl₃, Fe(CF₃SO₃)₃, p-Fluoranil, p-Chloranil, o-Bromatil, Dichlor-2,3-dizyan-5,6-p-benzochinon, Br₂, I₂, und CuCl₂ ausgewählt wird.

8. Verfahren zur Bildung eines Photoresistmotivs auf einer Oberfläche eines Siliziumsubstrats, **dadurch gekennzeichnet, daß** es umfaßt:
- das Aufbringen einer Photoresistlösung, die eine Novolak-Matrix, ein Molekül vom Typ Diazonaphthochinon und Eisen(III)-chlorid enthält, auf der Oberfläche des Siliziumsubstrats in Form einer dünnen, einheitlichen und homogenen Schicht mit einer Dicke zwischen 0,1 und 2 µm,
- das Erhitzen des Substrats und der dünnen Schicht, um die Photoresistschicht zu verdichten;
- das Anbringen einer Glasmaske, die mit einem Motiv versehen ist, über der Photoresistschicht;
- das Bilden eines latenten Bildes des Motivs der Maske in der Photoresistschicht durch Bestrahlung durch die Maske mit einem UV-Licht;
- das Brennen der bestrahlten Photoresistschicht;
- das Entwickeln des Bildes des Motivs in der Photoresistschicht;
- das Trocknen des Substrats und der Schicht; und
- die Diffusion eines Pyrroldampfes in dem Photoresistmotiv während 2 bis 10 Stunden, um ein leitendes copolymerisiertes Photoresistmotiv auf dem Substrat zu bilden.

9. Verfahren nach Anspruch 8, **dadurch gekennzeichnet, daß** der Schritt der Erhitzung darin besteht, das Substrat und die dünne Schicht auf 90 °C 1 Minute lang zu erhitzen.

10. Verfahren nach Anspruch 8 oder 9, **dadurch gekennzeichnet, daß** das Brennen bei 120 °C während 1 Minute erfolgt.

11. das Verfahren nach einem der Ansprüche 8 oder 10, **dadurch gekennzeichnet, daß** der Schritt der Diffusion des Pyrroldampfes 5 Stunden lang erfolgt.

12. Verwendung für die Bildung eines copolymerisierten Photoresistmotivs einer Photoresistlösung auf einer Oberfläche eines Substrats nach dem Verfahren des Anspruchs 1 oder 8, umfassend eine Matrix aus einem polymeren Material, eine photosensible Verbindung und eine oxidierende Verbindung, die in der Lage ist, die Polymerisation eines Reduktionsmonomers hervorzurufen, das unter dem Pyrrol, dem Thiophen und ihren Derivaten ausgewählt wird, welche oxidierende Verbindung in der Photoresistlösung löslich und in der Lage ist, eine feste homogene Lösung in der dünnen Photoresistschicht zu bilden, die chemisch inert, thermisch stabil ist und eine begrenzte Absorbierfähigkeit in dem Wellenlängenbereich zwischen 190 und 450 nm aufweist.

13. Verwendung nach Anspruch 12, bei der die oxidierende Verbindung unter FeCl₃, Fe(CF₃SO₃)₃, p-Fluoranil, p-Chloranil, o-Bromatil, Dichlor-2,3-dizyan-5,6-p-benzochinon, Br₂, I₂, und CuCl₂ ausgewählt wird.

14. Verwendung nach Anspruch 12 oder 13, bei der die Matrix des polymeren Materials ein Novolak, ein Polyimid oder ein Polyvinylphenol ist.

15. Verwendung nach Anspruch 14, bei der die Matrix ein Novolak, die photosensible Verbindung ein Diazonaphthochinon und die oxidierende Verbindung Eisen(III)-chlorid ist.

16. Verwendung nach Anspruch 15, bei der die Photoresistlösung im Volumen 1 Teil einer Photoresistlösung, die kein Eisen(III)-chlorid enthält, und 0,2 bis 1,5 Teile dieser selben Lösung, gesättigt mit Eisen(III)-chlorid, umfaßt.

17. Photoresistlösung, die bei dem Verfahren nach Anspruch 1 oder 8 eingesetzt wird, umfassend eine Matrix eines polymeren Materials und eine photosensible Verbindung, **dadurch gekennzeichnet, daß** sie ferner eine oxidierende Verbindung umfaßt, die unter FeCl₃, Fe(CF₃SO₃)₃, Dichlor-2,3-dizyan-5,6- p-Benzochinon, und CuCl₂ ausgewählt wird.

18. Photoresistlösung nach Anspruch 17, **dadurch gekennzeichnet, daß** die Materialmatrix ein Novolak, ein Polyimid oder ein Polyvinylphenol ist.

19. Photoresistlösung nach Anspruch 18, **dadurch gekennzeichnet, daß** die Matrix ein Novolak, die photosensible Verbindung ein Diazonaphthochinon und die oxidierende Verbindung Eisen(III)-chlorid ist.

20. Photoresistlösung nach Anspruch 19, **dadurch gekennzeichnet, daß** sie im Volumen einen Teil einer Photoresistlösung, die kein Eisen(III)-chlorid enthält, und 0,2 bis 1,5 Teile dieser selben Lösung, gesättigt mit Eisen(III)-chlorid, umfaßt.

## Claims

1. Process for forming a photoresist pattern on a surface of a substrate, for example made of a semiconductor material such as silicon, **characterized in that** it comprises:
- the deposition of a photoresist solution containing an oxidizing compound in the form of a uniform and homogeneous thin film on the surface of the substrate, the oxidizing compound being capable of oxidizing a reducing monomer, soluble in the photoresist solution, which can form a homogeneous solid solution in the thin, chemically insert and thermally stable photoresist film having a limited absorbence in the range of wavelengths of between 190 and 450 nm;
- the heating of the substrate and of the thin film in order to densify the photoresist film
- the positioning of a mask provided with a pattern over the photoresist film;
- the formation, by irradiating the photoresist film through the mask, of a latent image of the pattern;
- the development in the photoresist film of the image of the pattern and
- the diffusion into the photoresist pattern of the vapour of a reducing monomer in order to form a conducting copolymerized photoresist pattern on the substrate, the reducing monomer being chosen from pyrrole and its derivatives and thiophene and its derivatives.

2. Process according to Claim 1, furthermore including a step of drying the film after the image of the pattern has been developed but before the monomer vapour diffusion.

3. Process according to Claim 1 or 2, furthermore including an annealing step after the irradiation but before the development step.

4. Process according to either of the preceding Claims 1 or 2, **characterized in that** the thin film of photoresist solution is deposited by spin coating.

5. Process according to any one of the preceding claims, **characterized in that** the thin film of photoresist solution has a thickness of 0.1 to 2 µm.

6. Process according to any one of the preceding claims, **characterized in that** the monomer vapour diffusion takes place over a period of 2 to 10 hours.

7. Process according to any one of the preceding claims, **characterized in that** the oxidizing compound is chosen from FeCl₃, Fe(CF₃SO₃)₃, p-fluoranil, p-chloranil, o-bromanil, 2,3-dichloro-5,6-dicyano-p-benzoquinone, Br₂, I₂ and CuCl₂.

8. Process for forming a photoresist pattern on a surface of a silicon substrate, **characterized in that** it comprises:
- the deposition by spin coating, on the surface of the silicon substrate, of a photoresist solution containing a novolac matrix, a molecule of the diazonaphthoquinone type and ferric chloride, in the form of a thin, uniform and homogenous film having a thickness of between 0.1 and 2 µm;
- the heating of the substrate and of the thin film in order to obtain a density [sic] photoresist film;
- the positioning over the photoresist film of a glass mask provided with a pattern;
- the formation in the photoresist film, by irradiation through the mask with ultraviolet light, of a latent image of the pattern of the mask;
- the annealing of the irradiated photoresist film;
- the development in the photoresist film of the image of the pattern;
- the drying of the substrate and of the film; and
- the diffusion into the photoresist pattern of pyrrole vapour for 2 to 10 hours in order to form a conducting copolymerized photoresist pattern on the substrate.

9. Process according to Claim 8, **characterized in that** the heating step consists in heating the substrate and the thin film at 90°C for 1 minute.

10. Process according to Claim 8 or 9, **characterized in that** the annealing is carried out at 120°C for 1 minute.

11. Process according to either of Claims 8 and 10, **characterized in that** the pyrrole vapour diffusion step takes place over 5 hours.

12. Use for forming, on a surface of a substrate according to the process of Claim 1 or 8, a copolymerized photoresist pattern from a photoresist solution comprising a matrix of polymer material, a photosensitive compound and an oxidizing compound capable of causing polymerization of a reducing monomer chosen from pyrrole, thiophene and derivatives thereof, the said oxidizing compound being soluble in the photoresist solution, which is capable of forming a homogeneous solid solution in the thin, chemically inert and thermally stable photoresist film having a limited absorbence in the range of wavelengths between 190 and 450 nm.

13. Use according to Claim 12, in which the oxidizing compound is chosen from FeCl₃, Fe(CF₃SO₃)₃, p-fluoranil, p-chloranil, o-bromanil, 2,3-dichloro-5,6-dicyano-p-benzoquinone, Br₂, I₂ and CuCl₂.

14. Use according to Claim 12 or 13, in which the matrix of polymer material is a novolac, a polyimide or a polyvinyl phenol.

15. Use according to Claim 14, in which the matrix is a novolac, the photosensitive compound is a diazonaphthoquinone and the oxidizing compound is ferric chloride.

16. Use according to Claim 15, in which the photoresist solution comprises, by volume, one part of photoresist solution not containing ferric chloride and 0.2 to 1.5 parts of this same solution saturated with ferric chloride.

17. Photoresist solution used in the process according to Claim 1 or 8, comprising a matrix of polymer material and a photosensitive compound, **characterized in that** it furthermore includes an oxidizing compound chosen from FeCl₃, Fe(CF₃SO₃)₃, 2,3-dichloro-5,6-dicyano-p-benzoquinone, and CuCl₂.

18. Photoresist solution according to Claim 17, **characterized in that** the matrix of [lacuna] material is a novolac, a polyimide, or a polyvinyl phenol.

19. Photoresist solution according to Claim 18, **characterized in that** the matrix is a novolac, the photosensitive compound a diazonaphthoquinone and the oxidizing compound ferric chloride.

20. Photoresist solution according to Claim 19, **characterized in that** it comprises, by volume, one part of photoresist solution not containing ferric chloride and 0.2 to 1.5 parts of this same solution saturated with ferric chloride.
